# FASCICULE DE BREVET EUROPEEN

(11) **EP 2 494 570 B1**
(45) Date de publication et mention de la délivrance du brevet: **25.02.2015**
(21) Numéro de dépôt: 10768936.6
(22) Date de dépôt: 25.10.2010
(51) Int. Cl.: H01H 9/52, F21V 29/00, F28D 15/02, H01L 23/427, H05K 7/20

(54) **PROCEDE ET DISPOSITIF DE REFROIDISSEMENT D'UNE INSTALLATION ELECTRIQUE MOYENNE TENSION SOUS GAINE**
VERFAHREN UND VORRICHTUNG ZUR KÜHLUNG EINER UMMANTELTEN ELEKTRISCHEN MITTELSPANNUNGSANLAGE
METHOD AND DEVICE FOR COOLING A JACKETED MEDIUM-VOLTAGE ELECTRICAL INSTALLATION

(30) Priorité: 26.10.2009 FR 0957480
(43) Date de publication de la demande: 05.09.2012
(73) Titulaire: Alstom Technology Ltd., 5400 Baden (CH)
(72) Inventeur: FRIGIERE, Denis, 69150 Decines (FR); RODRIGUES, Didier, 38200 Serpaize (FR); WILLIEME, Jean-Marc, 69350 La Mulatiere (FR); JACQUIER, Frank, 69780 Mions (FR)
(74) Mandataire: Ilgart, Jean-Christophe
(86) Numéro de dépôt international: PCT/EP2010/066010
(87) Numéro de publication internationale: WO 2011/051195

(56) Documents cités:
- EP-A1- 1 657 731
- DE-A1- 2 900 761
- DE-A1- 3 941 388
- US-A- 3 662 137

## Description

### Domaine de l'invention

L'invention concerne le domaine des disjoncteurs ou des sectionneurs de générateurs fonctionnant à moyenne tension, placés dans une gaine de protection et utilisant des dispositifs de refroidissement fonctionnant avec un fluide caloporteur à changement de phase, appelés "caloducs".

On rappelle qu'un caloduc se présente sous la forme d'une enceinte allongée hermétique renfermant un fluide en équilibre avec sa phase gazeuse et sa phase liquide, en l'absence de tout autre gaz. On pense, entre autres, dans le cas présent à l'eau, l'alcool, l'acétone.

### Art antérieur et problème posé

Le souci permanent des constructeurs de ce type de matériel est d'augmenter la capacité de ces appareils à passer des courants d'ampérage de plus en plus importants, notamment au niveau des disjoncteurs et sectionneurs placés à l'intérieur de jeux de barres à la sortie de centrales productrices ou de distribution de courant électrique. C'est notamment le cas des disjoncteurs d'alternateurs.

Une méthode, généralement utilisée, consiste à homogénéiser la température de l'air en contact avec les différentes parties chauffantes et chauffées du disjoncteur concerné. Le refroidissement à l'intérieur d'une telle gaine de protection peut se faire par convexion naturelle ou forcée de l'air enfermé dans celle-ci et dans laquelle se trouve le disjoncteur, la température régnant à l'intérieur de celle-ci étant notablement supérieure à la température régnant à l'extérieur, c'est-à-dire de 30°C à au moins 40°C. Toutefois, l'utilisation de tels appareils auxiliaires, tels que des ventilateurs, présentent plusieurs inconvénients qui sont une consommation d'énergie électrique prélevée sur le circuit principal, un risque de perte de ces ventilateurs auxiliaires d'où une nécessité de les doubler ou de prévoir des modes de fonctionnement dégradés, des bruits, un fort encombrement.

Une autre solution consiste à prévoir une augmentation de la section de passage du courant dans les différents éléments de transmission, donc de passer par une augmentation de la taille des pièces des disjoncteurs.

D'autre part, par le document de brevet EP 1 657 731, on connaît un dispositif et un procédé de refroidissement d'un disjoncteur ou d'un sectionneur de haute tension. La figure 1 montre, en coupe, une réalisation décrite dans ce document. Elle représente principalement un conducteur de haute tension ou le carter d'un disjoncteur. Celui-ci est entouré d'évaporateurs 3 faisant partie d'un ensemble de refroidissement 1 de celui-ci. Un tel ensemble se complète d'un manchon d'isolation 7 entourant un dispositif fonctionnant avec un fluide caloporteur à changement de phase 5 pour évacuer la chaleur collectée par les évaporateurs 3. Un manchon élastique 9 complète l'ensemble. Le tout est placé l'intérieur d'une gaine de protection 8. L'ensemble de refroidissement débouche sur le toit de cette gaine de protection 8 pour aboutir à un dispositif de condensation 4, par exemple à ailettes.

Le but de l'invention est de proposer une solution différente de ce type d'installation.

Le document US 3 662 137 A décrit un procédé de refroidissement d'une installation de traitement et de transfert d'électricité selon le préambule de la revendication 1.

### Résumé de l'invention

La conception du procédé et du dispositif selon l'invention consiste donc à refroidir, non pas l'appareil électrique concerné et installé dans une gaine, mais de refroidir la gaine elle-même.

Un premier objet principal de l'invention est un procédé de refroidissement d'une installation de traitement de transport d'électricité sous moyenne tension et fort ampérage comprenant des appareillages de transport et de coupure de courant placés sous gaines.

Selon l'invention, le procédé consiste à refroidir les parois de la ou des gaines avec des éléments de refroidissement à liquide caloporteur à changement de phase.

Dans une première mise en oeuvre de ce procédé, on utilise, pour la gaine, des parois du type à double paroi pour y intégrer une partie des éléments à fluide caloporteur à changement de phase.

Dans une deuxième réalisation de l'invention, on utilise des caloducs équipés d'ailettes placées sur les parois de la ou des gaines.

Dans une variante, les moyens de refroidissement à liquide caloporteur sont des caloducs verticaux et intégrés dans une plaque verticale plaquée contre la gaine.

Un deuxième objet principal de l'invention est un dispositif de refroidissement d'une installation de traitement et de transport d'électricité sous moyenne tension et à fort ampérage comprenant des appareils de transport et de coupure de courant placés sous gaines.

Selon l'invention, on utilise des moyens de refroidissement de la gaine par liquide caloporteur à changement de phase.

Dans une première réalisation de ce dispositif, on prévoit que les parois de la gaine soient doubles et qu'il comprenne des éléments à liquide caloporteur à changement de phase dont une partie est placée dans les doubles parois de la ou des gaines pour obtenir la vaporisation du liquide caloporteur, l'autre partie de ces éléments étant reliée à des condenseurs.

Dans ce cas, de préférence, on place le ou les condenseurs sur le toit de la gaine.

Il s'avère alors intéressant d'utiliser éventuellement des moyens de ventilation forcée des condenseurs.

Une deuxième réalisation préférentielle de l'invention prévoit que les moyens de refroidissement de la gaine soient des caloducs dont une partie est encastrée dans la paroi de la gaine ou en contact thermique avec les parois des gaines et que ces caloducs soient équipés de moyens de condensation.

Dans ce cas, il est préférable de réaliser les moyens de condensation des caloducs sous la forme d'ailettes placées perpendiculairement autour de ceux-ci.

Les caloducs peuvent également être encastrés dans une plaque verticale plaquée contre la gaine.

Dans le cas où plusieurs gaines sont installées parallèlement les unes à côté des autres, il s'avère intéressant d'utiliser alors des moyens de ventilation forcés entre ces gaines.

### Liste des figures

L'invention et ses différentes caractéristiques seront mieux comprises à la lecture de la description suivante qui est accompagnée de cette figure représentant respectivement :
- figure 1, déjà décrite, en coupe, un dispositif de refroidissement selon l'art antérieur ;
- figures 2A, 2B et 2C, en coupe, une première réalisation du dispositif de refroidissement selon l'invention ;
- figures 3A, 3B et 3C, une deuxième réalisation du dispositif de refroidissement selon l'invention, et
- figure 4, en coupe, une troisième réalisation du dispositif de refroidissement selon l'invention.

### Description détaillée des deux réalisations de l'invention

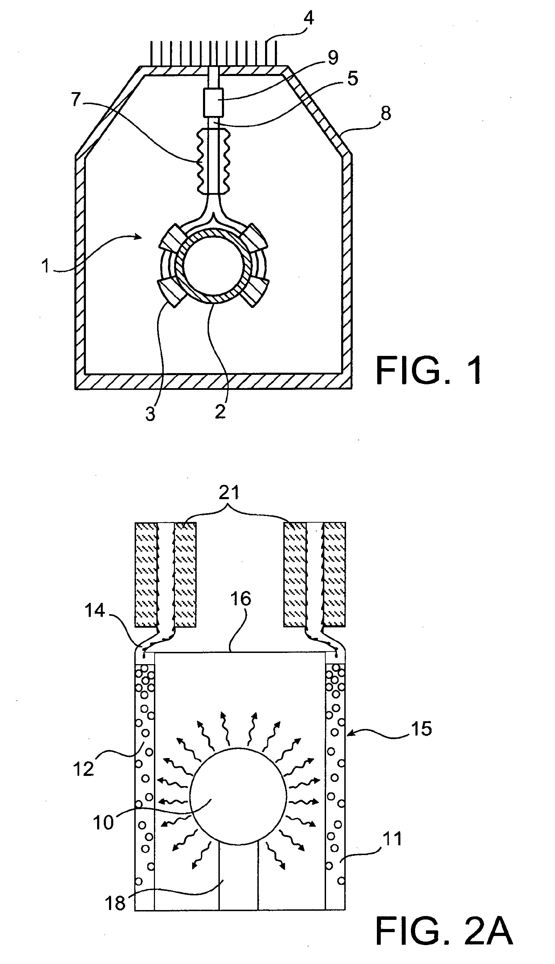

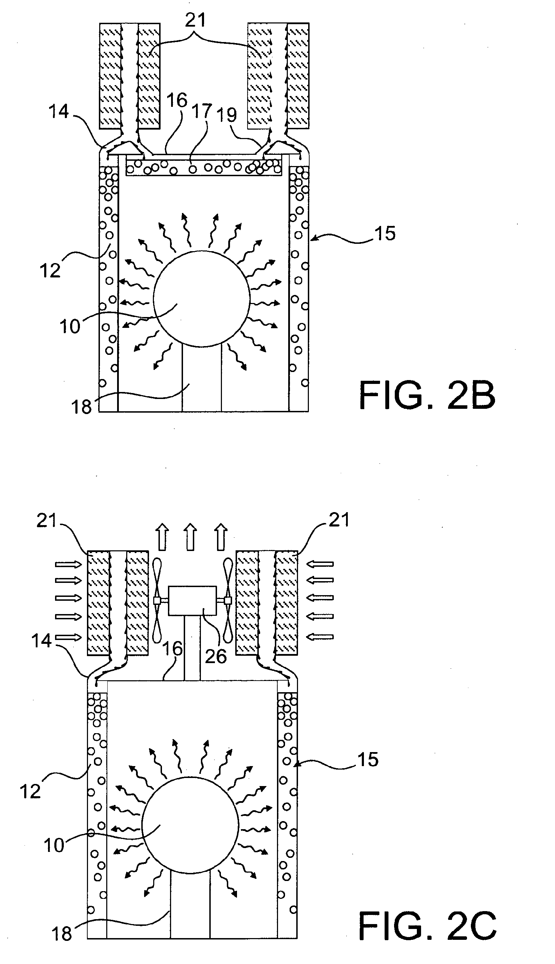

Les figures 2A, 2B et 2C représentent, en coupe, les trois phases de l'installation d'un disjoncteur de générateur (GCB). Sur chacune de ces figures 2A, 2B et 2C, un appareil électrique moyenne tension 10, par exemple un disjoncteur, un sectionneur ou un conducteur, a été représenté, installé horizontalement sur un support isolant 18, le tout étant placé dans une gaine 19. Les flèches brisées placées autour de cet appareillage 10 montrent que celui-ci diffuse beaucoup de chaleur à l'intérieur de la gaine 15.

Il est prévu que cette gaine 15 possède des parois latérales 12 en double paroi de manière à pouvoir y installer des évaporateurs 11 qui font partie d'un système de refroidissement utilisant un fluide caloporteur à changement de phase. On comprend que les parois latérales 12 de la gaine 15 soient donc chauffées par la chaleur dispensée par l'appareil 10 et puissent provoquer une évaporation au moins partielle du fluide contenu dans l'évaporateur 11 du dispositif de refroidissement à changement de phase. On signale que, dans l'application prévue, la température des parois latérales 12 de la gaine 15 est d'environ 80°C.

Les évaporateurs 11 placés dans les parois latérales 12 de la gaine 15 sont reliés, par des conduits 14, à des condenseurs 21 disposés sur le toit 16 de la gaine 15. Ainsi, ces condenseurs 21 peuvent être balayés par l'air ambiant du local dans lequel se trouve l'installation électrique. La chaleur ainsi rayonnée par cette installation électrique, due principalement à l'échauffement des gaines 15 est ainsi évacuée dans l'atmosphère.

La figure 2B montre que le toit 16 de la gaine 15 peut également être équipé d'une double paroi 18 dans laquelle se trouve un évaporateur 17 relié également à un condenseur 21 se trouvant sur le toit 16 de la gaine 15. Ainsi, un maximum de chaleur peut être évacué.

La figure 2C montre que cette installation peut être complétée de moyens de ventilation 26 placés entre les deux condenseurs 21 placés chacun sur un toit 16 d'une gaine 15.

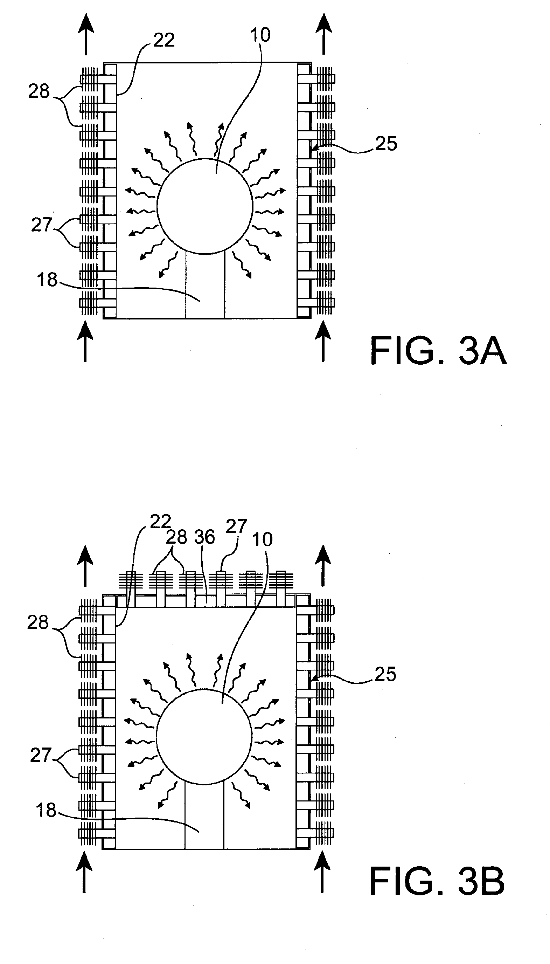

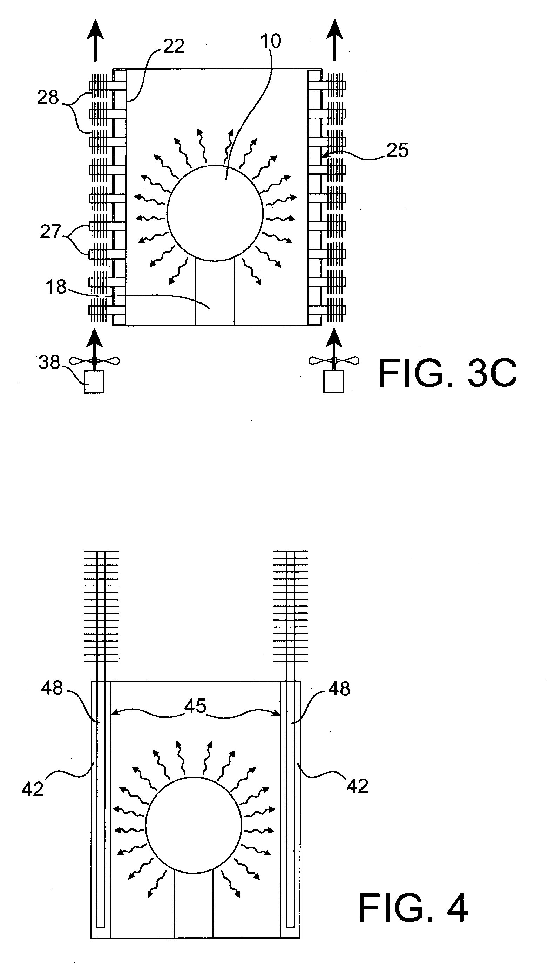

Une deuxième réalisation possible est illustrée par les figures 3A, 3B et 3C représentant respectivement les trois phases d'un jeu de barres ou d'une installation de sortie de centrale électrique avec un disjoncteur de générateur (GCB). On y retrouve l'appareil 10 pouvant toujours être un disjoncteur, un sectionneur ou un conducteur placé sur son support isolant 18. Les parois 22 de la gaine 25 dans laquelle se trouve cet appareil 10 ne sont plus des structures à double paroi mais sont équipées de caloducs 27 dont une partie est encastrée dans ces parois 22. Chaque caloduc 27 peut être équipé d'un certain nombre d'ailettes 28 placées perpendiculairement au caloduc 27. Ainsi, la chaleur emmagasinée dans chaque paroi latérale 22 de la gaine 25 est répartie dans le caloduc. On organise alors une ventilation le long des parois latérales 22 des gaines 25. Cette convexion est naturelle sur la figure 3A, tandis que qu'elle est forcée sur la figure 3C grâce à des moyens de ventilation verticaux 38, et placée à côté et en dessous des parois latérales 22 de la gaine concernée 25. On comprend que la convexion naturelle entre deux gaines 25 voisines est un facteur favorable pour l'évacuation de la chaleur dispensée par les appareils 10.

Sur la figure 3B, on y montre à l'instar de la figure 2B, qu'il est possible d'équiper un plafond 36 de la gaine 25 également de caloducs 27 toujours équipés eux-mêmes d'ailettes 28.

La figure 4 montre une variante de celle des figures 2A et 2B. Les caloducs 48 verticaux sont encastrés dans une plaque verticale 42 qui est plaquée contre la paroi de la gaine 45. Ici, la plaque verticale 42 et les caloducs 48 sont à l'extérieur de la gaine 45, mais on peut les mettre à l'intérieur.

### Avantages de l'invention

Le procédé de refroidissement selon l'invention fait que le système n'est en aucun point en contact avec les parties sous tension de l'installation électrique.

Sa consommation en énergie n'est limitée qu'à l'utilisation éventuelle de moyens de ventilation 26 et 36.

Enfin, le dispositif selon l'invention ne nécessite qu'une maintenance qui est limitée au nettoyage éventuel des ailettes 28, même si l'appareil est sous tension.

## Revendications

1. Procédé de refroidissement d'une installation de traitement et de transfert d'électricité sous moyenne tension et à fort ampérage comprenant des appareils (10) de transport et de coupure de courant placés sous gaines (15, 25),
**caractérisé en ce qu'**il consiste à refroidir les parois (12, 22, 18, 26) de la ou des gaines (15, 25) avec des éléments de refroidissement à liquide caloporteur à changement de phase placés directement en contact avec les parois (12, 22, 18, 26) de la ou des gaines (15, 25).

2. Procédé selon la revendication 1, **caractérisé en ce qu'**il consiste à utiliser des parois (12, 18) de la gaine (15) qui sont à double paroi pour pouvoir y intégrer une partie des éléments à fluide caloporteur à changement de phase.

3. Procédé selon la revendication 1, **caractérisé en ce qu'**il consiste à utiliser des caloducs (48) encastrés verticalement dans une plaque verticale (42) plaquée contre la gaine (45).

4. Procédé selon la revendication 1, **caractérisé en ce qu'**il consiste à utiliser des caloducs (27) placés sur les parois de la gaine (25).

5. Dispositif de refroidissement d'une installation de traitement et de transport d'électricité sous moyenne tension et à fort ampérage, comprenant des appareils (17) de transport et de coupure de courant placés sous gaines,
**caractérisé en ce qu'**il comprend des moyens de refroidissement de la gaine (15, 25) fonctionnant avec un liquide caloporteur à changement de phase placés directement en contact avec la gaine (15, 25), pour refroidir directement la gaine.

6. Dispositif selon la revendication 5, **caractérisé en ce que** des parois latérales (12) de la gaine (25) sont doublées et qu'on utilise des évaporateurs (11) fonctionnant avec un liquide caloporteur à changement de phase dont une partie est placée dans la double paroi pour vaporiser le liquide caloporteur, l'autre partie de l'évaporateur étant reliée à des condenseurs (21).

7. Dispositif selon la revendication 6, **caractérisé en ce que** les condenseurs (21) sont placés sur le toit (16) de la gaine (15).

8. Dispositif selon la revendication 7, **caractérisé en ce qu'**il comprend des moyens de ventilation forcés (26) placés sur le toit (16) de la ou des gaines (15) latéralement au condenseur (21).

9. Dispositif selon la revendication 5, **caractérisé en ce que** les moyens de refroidissement sont des caloducs (27), dont une partie est encastrée dans des parois de la gaine (25) et sont équipés de moyens de condensation.

10. Dispositif selon la revendication 9, **caractérisé en ce que** les moyens de condensation sont des ailettes (28) montées perpendiculairement autour des caloducs (27).

11. Dispositif selon la revendication 5, **caractérisé en ce que** les moyens de refroidissement sont des caloducs (48) verticaux encastrés dans une plaque verticale (42) plaquée contre la paroi latérale de la gaine (45).

12. Dispositif selon la revendication 9, **caractérisé en ce qu'**il comprend des moyens de ventilation forcés (38) pour favoriser la ventilation ascendante entre les gaines (25).

## Patentansprüche

1. Verfahren zum Kühlen einer Mittelspannungsanlage mit hoher Stromstärke zur Erzeugung und Übertragung von Elektrizität, die Vorrichtungen (10) zum Übertragen und Unterbrechen von Strom aufweist, die in Mänteln (15, 25) angeordnet sind,
**dadurch gekennzeichnet, dass** es darin besteht, die Wände (12, 22, 18, 26) des Mantels bzw. der Mäntel (15, 25) über Kühlelemente mit Wärmeträgerflüssigkeit mit Phasenwechsel zu kühlen, die in direktem Kontakt mit den Wänden (12, 22, 18, 26) des Mantels bzw. der Mäntel (15, 25) angeordnet sind.

2. Verfahren nach Anspruch 1, **dadurch gekennzeichnet, dass** es darin besteht, Wände (12, 18) des Mantels (15) zu verwenden, die doppelwandig ausgeführt sind, um darin einen Teil der Elemente mit Wärmeträgerflüssigkeit mit Phasenwechsel zu integrieren.

3. Verfahren nach Anspruch 1, **dadurch gekennzeichnet, dass** es darin besteht, Wärmerohre (48) zu verwenden, die vertikal in einer vertikal verlaufenden Platte (42) eingebettet sind, die an den Mantel (45) angedrückt wird.

4. Verfahren nach Anspruch 1, **dadurch gekennzeichnet, dass** es darin besteht, Wärmerohre (27) zu verwenden, die an den Wänden des Mantels (25) angeordnet sind.

5. Vorrichtung zum Kühlen einer Mittelspannungsanlage mit hoher Stromstärke zur Erzeugung und Übertragung von Elektrizität, die Einrichtungen (17) zum Übertragen und Unterbrechen von Strom aufweist, die in Mänteln angeordnet sind,
**dadurch gekennzeichnet, dass** sie Mittel zum Abkühlen des Mantels (15, 25) aufweist, die mit einer Wärmeträgerflüssigkeit mit Phasenwechsel betrieben werden, die in direktem Kontakt mit dem Mantel (15, 25) angeordnet sind, um den Mantel direkt zu kühlen.

6. Vorrichtung nach Anspruch 5, **dadurch gekennzeichnet, dass** die Seitenwände (12) des Mantels (25) doppelwandig sind und dass Verdampfer (11) verwendet werden, die mit einer Wärmeträgerflüssigkeit mit Phasenwechsel betrieben werden, von denen ein Teil in der Doppelwandung angeordnet ist, um die Wärmeträgerflüssigkeit zu verdampfen, bei der andere Teil der Verdampfer mit den Kondensatoren (21) verbunden ist.

7. Vorrichtung nach Anspruch 6, **dadurch gekennzeichnet, dass** die Kondensatoren (21) an der Abdeckung (16) des Mantels (15) angeordnet sind.

8. Vorrichtung nach Anspruch 7, **dadurch gekennzeichnet, dass** sie Zwangsbelüftungsmittel (26) aufweist, die an der Abdeckung (16) des bzw. der Mäntel (15) seitlich vom Kondensator (21) angeordnet sind.

9. Vorrichtung nach Anspruch 5, **dadurch gekennzeichnet, dass** die Kühlmittel Wärmerohre (27) sind, von denen ein Teil in den Wänden des Mantels (25) eingebettet ist und die mit Kondensationsmitteln ausgestattet sind.

10. Vorrichtung nach Anspruch 9, **dadurch gekennzeichnet, dass** die Kondensationsmittel Rippen (28) sind, die senkrecht um die Wärmeleitrohre (27) herum angebracht sind.

11. Vorrichtung nach Anspruch 5, **dadurch gekennzeichnet, dass** die Kühlmittel vertikal verlaufende Wärmerohre (48) sind, die in eine vertikal verlaufende Platte (42) eingebettet sind, die an die Seitenwand des Mantels (45) angedrückt wird.

12. Vorrichtung nach Anspruch 9, **dadurch gekennzeichnet, dass** sie Zwangsbelüftungsmittel (38) aufweist, um die aufsteigende Belüftung zwischen den Mänteln (25) zu begünstigen.

## Claims

1. A cooling method for cooling a medium-voltage, high-current installation for handling and transferring electricity, the installation including current-transporting and current-breaking gear (10) placed in sheath(s) (15, 25); the method being **characterized in that** it consists in cooling the walls (12, 22, 18, 26) of the sheath(s) (15, 25) with cooling elements having a phase-change heat-transfer liquid directly situated in contact with the walls (12, 22, 18, 26) of the sheath(s) (15, 25).

2. A method according to claim 1, **characterized in that** it consists in using the walls (12, 18) of the sheath (15), which walls are of the double-walled type in order to incorporate a portion of each element having a phase-change heat-transfer fluid.

3. A method according to claim 1, **characterized in that** it consists in using heat pipes (48) that are embedded vertically in a vertical plate (42) that is pressed against the sheath (45).

4. A method according to claim 1, **characterized in that** it consists in using heat pipes (27) that are placed on the walls of the sheath (25).

5. A cooling device for a medium-voltage, high-current installation for handling and transporting electricity, the installation including current-transporting and current-breaking gear (10) placed in sheaths; the device being **characterized in that** it includes cooling means of the sheath(s) (15, 25) operating with a phase-change heat-transfer liquid in order to cool directly the sheath(s) (15, 25) directly situated in contact with the sheath(s) (15, 25).

6. A device according to claim 5, **characterized in that** the side walls (12) of the sheath (25) are double walls and **in that** evaporators (11) are used that operate with a phase-change heat-transfer liquid, each evaporator having a portion that is placed in the double wall in order to vaporize the heat-transfer liquid, the other portion thereof being connected to condensers (21).

7. A device according to claim 6, **characterized in that** the condensers (21) are placed on the roof (16) of the sheath (15).

8. A device according to claim 7, **characterized in that** it includes fan means (26) for providing forced ventilation, which means are placed on the roof (16) of the sheath(s) (15) laterally relative to the condenser (21).

9. A device according to claim 5, **characterized in that** the cooling means are heat pipes (27), each having a portion embedded in a wall of the sheath (25), and **in that** the heat pipes are provided with condenser means.

10. A device according to claim 9, **characterized in that** the condenser means are fins (28) mounted perpendicularly around the heat pipes (27).

11. A device according to claim 5, **characterized in that** the cooling means are vertical heat pipes (48) embedded in a vertical plate (42) that is pressed against the side wall of the sheath (45).

12. A device according to claim 9, **characterized in that** it includes fan means (38) for providing forced ventilation in order to favor the upward ventilation between the sheaths (25).
